# EUROPEAN PATENT APPLICATION

(11) **EP 4 752 929 A1**
(43) Date of publication of application: **03.06.2026**
(21) Application number: 24216914.2
(22) Date of filing: 02.12.2024
(51) Int. Cl.: H01J 37/21

(54) **METHOD OF SELECTING A FOCAL POSITION OF A CHARGED PARTICLE-OPTICAL DEVICE, AND CHARGED PARTICLE-OPTICAL DEVICE**

(71) Applicant: ASML Netherlands B.V., 5500 AH Veldhoven (NL)
(72) Inventor: ZOLOTAREV, Evgeny, 5500 AH Veldhoven (NL); STEUNEBRINK, Martin, 5500 AH Veldhoven (NL); ANNEMA, Piter, Hessel, 5500 AH Veldhoven (NL)
(74) Representative: ASML Netherlands B.V.

(57) **Abstract**

A method of selecting a focal position of a charged particle-optical device, the method comprising: directing a charged particle beam towards a target surface and detecting a detection signal resulting therefrom while varying the focal position of the charged particle beam through a range of focal positions, thereby generating a plurality of detection signals associated with the respective focal positions; and selecting a focal position of the charged particle-optical device, wherein the selected focal position corresponds to a dip in the detection signal across the range of focal positions.

## Description

### FIELD

The present invention relates to techniques of selecting a focal position of a charged particle-optical device.

### BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

In order for the assessment apparatus to produce images that are adequately clear for structures of the sample to be measurable, it is necessary for the charged particle beam (i.e. the primary beam) to be adequately focused on the surface of the sample. One approach for determining an appropriate focal position of the charged particle beam is to perform a scan of the sample, and analyse the sharpness of the scan image. However, this approach may be slow because it may require time to scan the sample and to analyse the scan image. The image analysis may also be computationally intensive.

### SUMMARY

An object of the invention is to speed up the process of determining an appropriate focal position of the charged particle beam.

Another object of the invention is to reduce the computation resources required for determining an appropriate focal position of the charged particle beam.

In accordance with an embodiment, there is disclosed a method of selecting a focal position of a charged particle-optical device, the method comprising:
directing a charged particle beam towards a target surface and detecting a detection signal resulting therefrom while varying the focal position of the charged particle beam through a range of focal positions, thereby generating a plurality of detection signals associated with the respective focal positions; and
selecting a focal position of the charged particle-optical device, wherein the selected focal position corresponds to a dip in the detection signal across the range of focal positions.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts an alternative multi-beam charged particle-optical device, for example of the assessment apparatus of Figure 1;
- Figure 5 schematically depicts a charged particle-optical device array;
- Figure 6 schematically depicts an alternative multi-beam charged particle-optical device, for example of the assessment apparatus of Figure 1;
- Figure 7 schematically depicts a single beam charged particle-optical device, for example of the assessment apparatus of Figure 1;
- Figure 8 schematically depicts an alternative multi-beam charged particle-optical device, for example of the assessment apparatus of Figure 1;
- Figure 9 schematically depicts part of the multi-beam charged particle-optical device of Figure 8;
- Figure 10 schematically depicts a detector array in plan view;
- Figure 11 schematically depicts a detector element in cross-section;
- Figure 12 schematically depicts various focal positions of the charged particle beam;
- Figure 13 shows example scintillator responses at various focal positions; and
- Figure 14 shows an example electron detector response at various focal positions.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7-8%. It is desirable to determine defects quickly so as to maintain a high substrate throughput, defined as the number of substrates processed per hour.

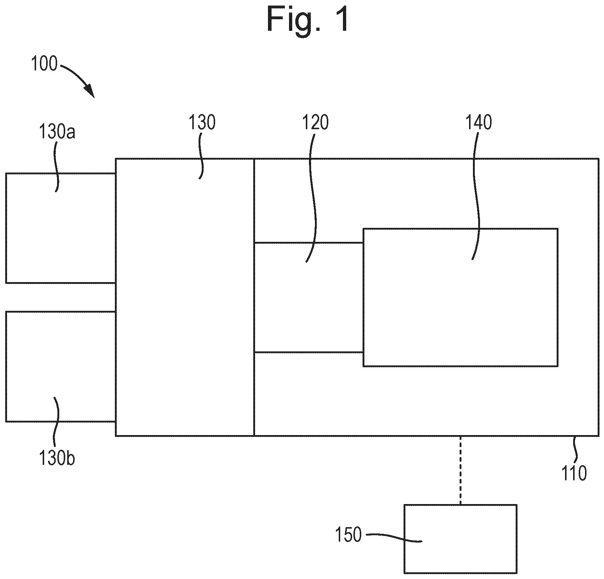

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

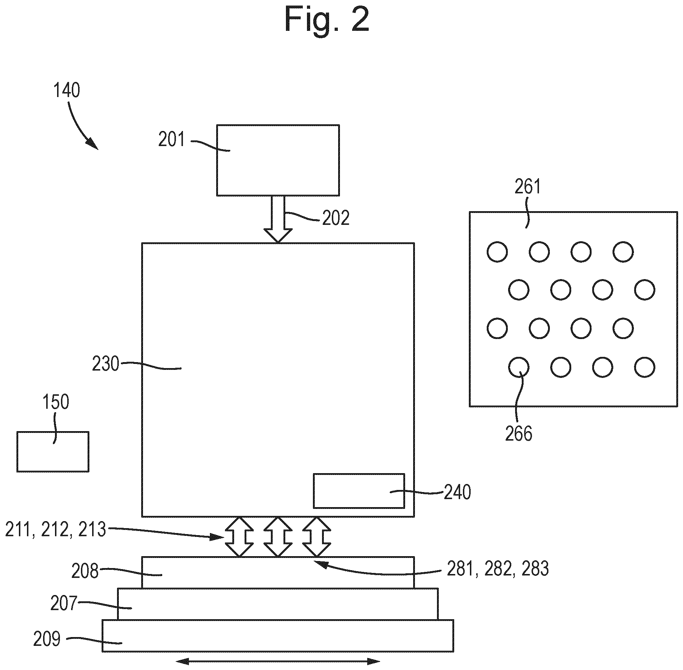

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

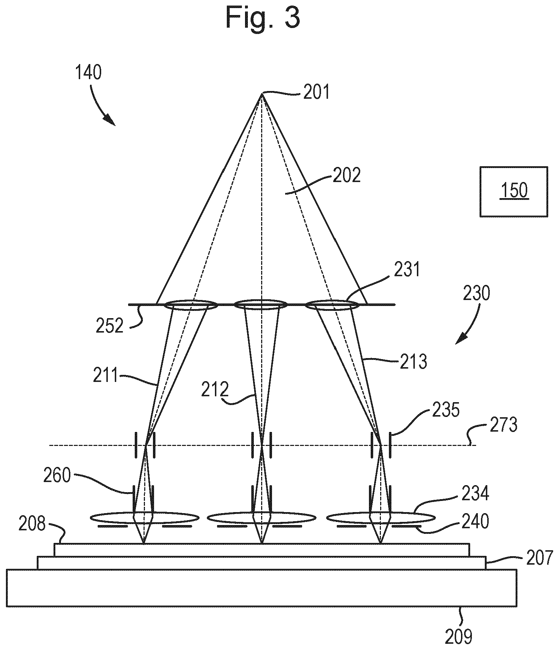

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

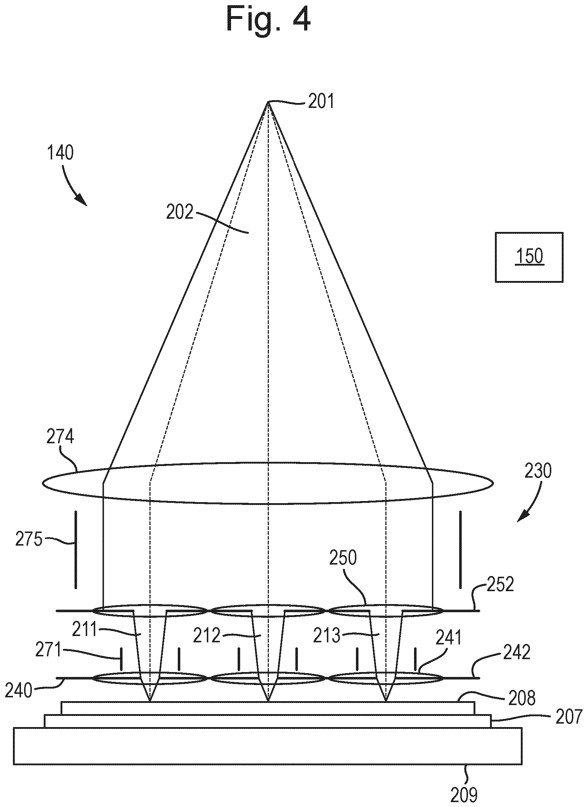

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

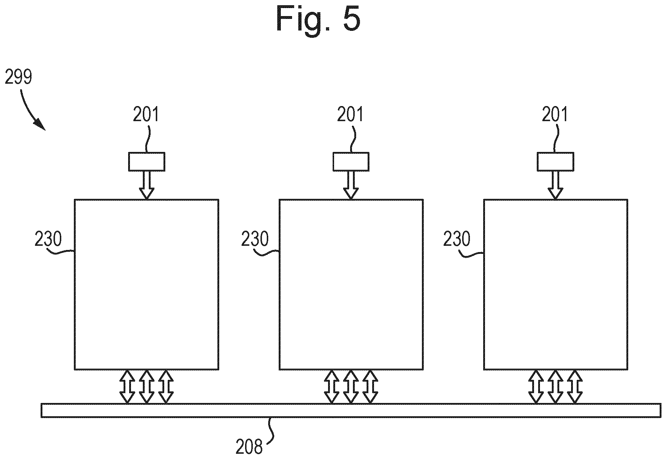

Figure 5 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

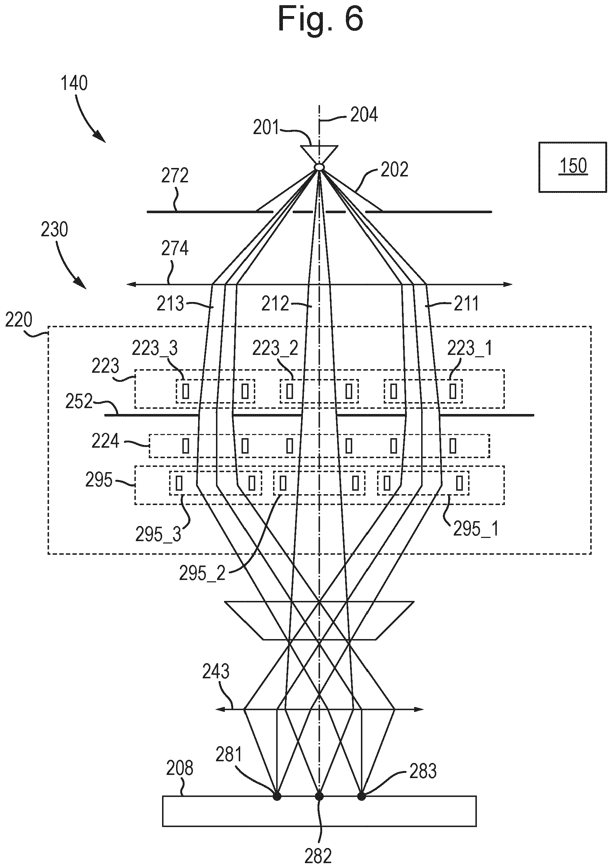

Figure 6 schematically depicts an electron-optical apparatus 140 of an assessment apparatus, e.g. the assessment apparatus 100 of Figure 1. The electron-optical apparatus 140 comprises an electron-optical device 230. The field of view of the electron-optical device 230 may be, for example, of the order of 100s of microns across the primary beams 211, 212, 213 at the sample 208. The electron-optical apparatus 140 of Figure 6 may be the electron-optical apparatus 140 of Figure 2 in which the electron-optical device 230 comprises a Coulomb aperture array 272, a macro condenser lens 274, a source converter (or micro-optical array) 220 and an objective lens 243. The electron-optical apparatus 140 defines an electron-optical axis 204. The Coulomb aperture array 272 may be referred to as a beam former array.

The source 201 generates a source beam 202. The Coulomb aperture array 272 defines a plurality of primary beams 211, 212, 213 from the source beam 202. The Coulomb aperture array 272, in operation, is configured to block off peripheral electrons to reduce electron-electron interactions (also referred to as Coulomb interactions) that may generate aberrations.

The macro condenser lens 274 is configured to at least partly collimate the primary beams 211, 212, 213. In an embodiment the macro condenser lens 274 is magnetic. The macro condenser lens 274 may be a non-rotational condenser lens. In an embodiment the macro condenser lens 274 is configured to operate on a plurality of, optionally all of, the primary beams 211, 212, 213.

The source converter 220 is configured to convert the primary beams 211, 212, 213 transmitted by the Coulomb aperture array 272 into the beams that are directed towards the sample 208. In an embodiment the source converter 220 is a module. Alternatively, the source converter 220 may comprise a plurality of separate electron-optical elements.

In an embodiment the source converter 220 comprises a pre-bending deflector array 223 with pre-bending deflectors 223_1, 223_2, 223_3 configured to deflect respective primary beams 211, 212, 213 toward a beam limiting aperture array 252.

In an embodiment the source converter 220 comprises a beam limiting aperture array 252 with an aperture pattern (i.e. apertures arranged in a formation) configured to define the outer dimensions of the primary beams 211, 212, 213 directed towards the sample 208. The beam limiting aperture array 252 may be a plate 261. In an embodiment, the beam limiting aperture array 252 defines a plurality of beams from each of the primary beams 211, 212, 213 directed to the beam limiting aperture array 252. In an alternative embodiment, the beam limiting aperture array 252 maintains the number of the primary beams 211, 212, 213 incident on the beam limiting aperture array 252.

The source converter 220 may comprise a corrector array such as an aberration reduction array 224 configured to reduce aberrations of the primary beams 211, 212, 213. In an embodiment the aberration reduction array 224 comprises a plurality of lenses configured to operate on respective primary beams 211, 212, 213. The aberration reduction array 224 may, for example, comprise a field curvature compensator array (not shown) comprising lenses. The aberration reduction array 224 may comprise an astigmatism compensator array (not shown) comprising stigmators. The stigmators may, for example, be controlled to operate on the primary beams 211, 212, 213 to reduce astigmatism aberrations.

The source converter 220 may comprise a deflector array 295 comprising deflectors 295_1, 295_2, 295_3 for the beam paths of respective primary beams 211, 212, 213. The deflectors 295_1, 295_2, 295_3 are configured to deflect the beam paths of the primary beams 211, 212, 213 towards the front focal plane of the objective lens 243 to ensure that the individual primary beams 211, 212, 213 will impinge on the sample 208 substantially perpendicular.

In an embodiment the objective lens 243 is magnetic. In an embodiment the objective lens 243 is a macroscopic lens configured to manipulate a plurality of, optionally all of, the primary beams 211, 212, 213 simultaneously. The objective lens 243 focuses the primary beams 211, 212, 213 onto the surface of the sample 208. The primary beams 211, 212, 213 form respective probe spots 281, 282, 283 on the surface of the sample 208. The deflectors 295_1, 295_2, 295_3 of the deflector array 295 deflect the individual primary beams 211, 212, 213 to the front focal plane of the objective lens to ensure that the individual primary beams 211, 212, 213, in use, impinge on the substrate 208 substantially perpendicular. In an embodiment the objective lens 243 is a macroscopic lens containing both magnetic and electrostatic lenses. In such an embodiment the macroscopic electrostatic lenses manipulate the plurality of the primary beams 211, 212, 213 simultaneously. In a further embodiment, the objective lens 243 comprises one or more scan deflectors (electrostatic and/or magnetic) to scan the plurality of primary beams 211, 212, 213 over the substrate 208.

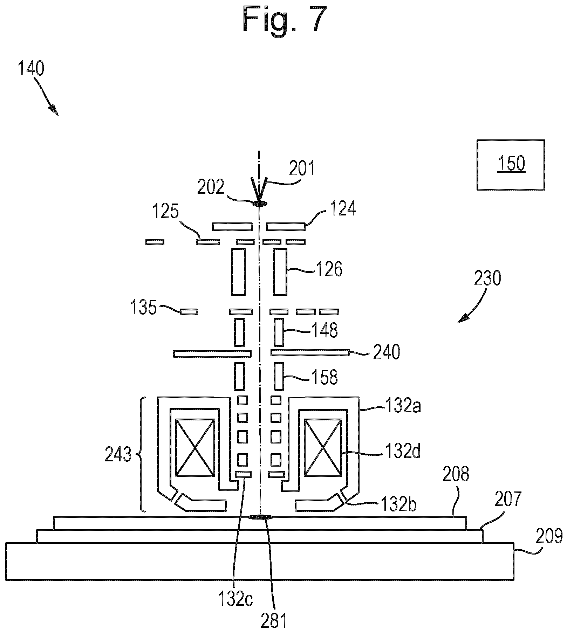

Figure 7 schematically depicts an electron-optical apparatus 140 of an assessment apparatus, e.g. the assessment apparatus 100 of Figure 1. As shown in Figure 7, in an embodiment the electron-optical apparatus 140 comprises an electron-optical device 230 that comprises a beam limit aperture 125 (the image actually shows an array of selectable beam limiting apertures), a condenser lens 126, a column aperture 135 (again indicated as an array of selectable column apertures 135), an objective lens 243 and a detector array 240.

The source 201 is configured to generate a source beam 202. A gun aperture 124 blocks peripheral electrons of the source beam 202. The source beam 202 passes through the beam limit aperture 125, the condenser lens 126 and the column aperture 135. The condenser lens 126 may be magnetic, electrostatic or a combination of magnetic and electrostatic.

In an embodiment the electron-optical device 230 comprises electromagnetic multipole, e.g. quadrupole, electron lenses. For example, the electron-optical device 230 may comprise a first multipole lens 148 and a second multipole lens 158. In an embodiment, the first multipole lens 148 and the second multipole lens 158 are used for controlling the source beam 202. For example, the first multipole lens 148 may be configured to adjust the beam current of the source beam 202. The second multipole lens 158 may be configured to adjust the size of the probe spot 281 and/or the shape of the source beam 202.

The objective lens 243 focuses the source beam 202 onto the sample 208. In an embodiment the objective lens 243 comprises a pole piece 132a, a control electrode 132b, a deflector 132c and an exciting coil 132d. In an embodiment a deflector, such as the deflector 132c or other deflectors in the objective lens 243 are configured to scan the source beam 202 across the surface of the sample 208. The detector array 240 is configured to detect signal electrons from the sample 208.

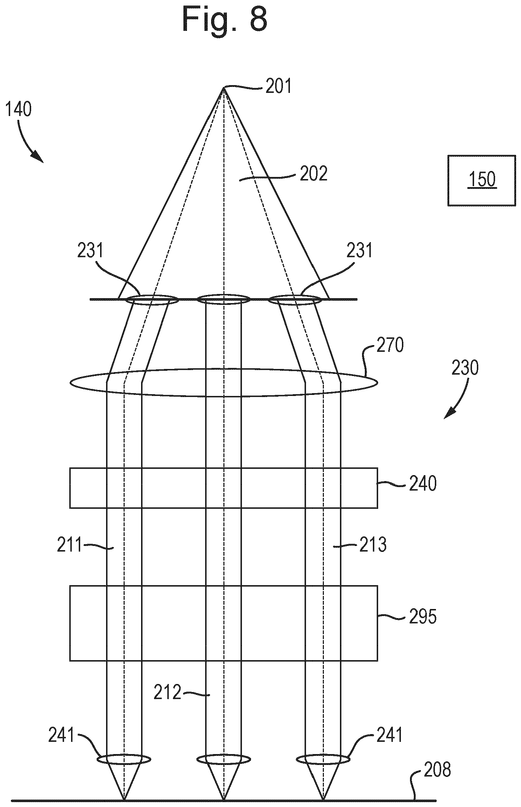

Figure 8 schematically depicts an electron-optical apparatus 140 of an assessment apparatus, e.g. the assessment apparatus 100 of Figure 1. The electron-optical apparatus 140 may be the electron-optical apparatus 140 of Figure 2 in which the electron-optical device 230 comprises a condenser lens array 231, a macro collimator 270, the detector array 240, a deflector array 295 and an objective lens array 241.

Features that are the same as those described above are given the same reference numerals. For conciseness, such features are not described in detail with reference to Figure 8. For example, the source 201, the condenser lens array 231, the objective lens array 241 and the sample 208 may be as described above.

The source is configured to generate a source beam 202. The condenser lens array 231 is configured to define a plurality of primary beams 211, 212, 213 from the source beam 202. The disclosure in EP1602121A1 of a lens array to split a beam into a plurality of beams, with the lens array providing a lens for each beam, is hereby incorporated by reference as a possible implementation of the condenser lens array 231.

In an embodiment the condenser lens array 231 comprises three plates 261 configured as an Einzel lens. An Einzel lens is configured to substantially ensure that the energy of an electron leaving the lens is the same as when the electron arrived at the lens. Such a lens maintains the energy of an electron between arriving and leaving the lens, for example the condenser lenses of the condenser lens array 231. Thus, dispersion only occurs within the condenser lens array 231 itself, thereby limiting chromatic aberrations. When a distance between the three plates of the Einzel lens is small, the chromatic aberrations caused by this condenser lens array 231 is limited, e.g. having a negligible effect.

In an embodiment the electron-optical device 230 comprises a collimator which may be macro collimator 270. The macro collimator 270 bends respective beams by an amount effective to ensure that a beam axis of each of the primary beams 211, 212, 213 derived from the primary 202 beam is incident on the sample 208 substantially normally (i.e. at substantially 90° to the nominal surface of the sample 208). In the current embodiment, the macro collimator 270 acts on all of the primary beams 211, 212, 213. The macro collimator 270 may comprise an electrostatic lens and/or a magnetic lens arrangement comprising a plurality of lens elements (e.g. a plurality of electrostatic and/or magnetic elements, e.g. forming a multipole).

In an embodiment the detector array 240 is configured to detect signal electrons by reference to the energy of the signal electron. For example, scintillators e.g. YAG do not directly detect electrons but generate light which is then detected. The signal electrons emitted from the sample 208 gain energy from the electromagnetic fields between the detector array 240 and the sample 208. In an embodiment, the objective lens array 241 is located between the detector array 240 and the sample 208.

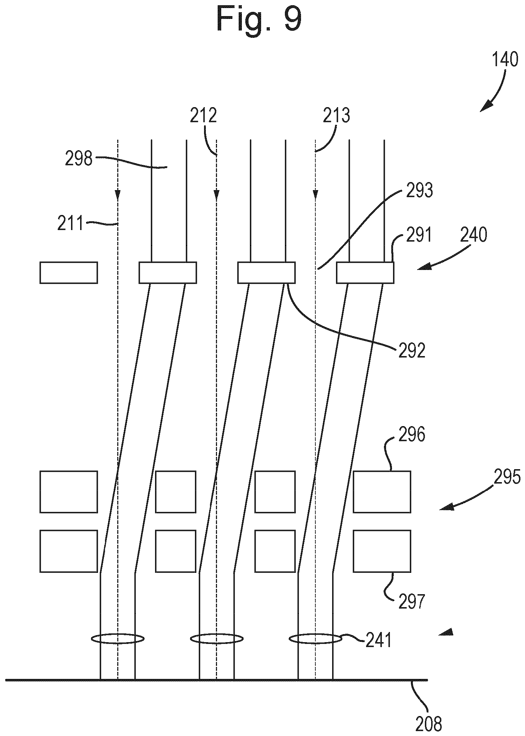

The electron-optical device 230 may comprise a deflector array 295 located between the detector array 240 and the objective lens array 241. The deflector array 295 may be referred to as a beam separator. The deflector array 295 may deflect signal electrons resulting from individual primary beams 211, 212, 213 along a path towards detector elements of a detector array 240 that is away from the paths of the primary beams towards the sample 208. The deflector array 295 may comprise a magnetic deflector array that is configured to provide magnetic fields to disentangle the primary electrons projected toward the sample 208 from the signal (e.g. secondary) electrons emitted from the sample 208. The deflector array 295 may comprise a Wien filter array. The deflector array 295 may comprise an electrostatic deflector array that is arranged to cooperate with the magnetic deflector array to achieve the disentangling of the paths of the primary electrons and signal electrons. Figure 9 is a close-up view of part of the electron-optical device 230 shown in Figure 8. In an embodiment the detector array 240 comprises an electron to photon converter array 291, e.g. a scintillator array. The electron to photon converter array 291 comprises a plurality of fluorescent elements (e.g. comprising YAG) which may be in the form of fluorescent strips 292 extending across the beam grid. Each fluorescent strip 292 is located in the plane of the electron to photon converter array 291. At least one fluorescent strip 292 is arranged between two adjacent primary beams 211, 212, 213 projected towards the sample 208. In an embodiment, the fluorescent strips 292 extend substantially across the beam grid. Alternatively, the electron to photon converter array 291 may comprise a plate of a fluorescent material with openings 293 for the primary beams 211, 212, 213 or an array of elements of similar size around the beams and that may be spaced apart. The primary beams 211, 212, 213 are projected through the plane of the electron to photon converter array 291, e.g. via the openings 293 such as between the fluorescent strips 292, towards the deflector array 295.

In an embodiment the deflector array 295 comprises a magnetic deflector 296 and an electrostatic deflector 297. The electrostatic deflector 297 is configured to counteract the deflection of the magnetic deflector 296 for the primary beams 211, 212, 213 transmitted towards the sample 208. Accordingly, the primary beams 211, 212, 213 may be shifted to a small extent in the horizontal plane. The beam paths downbeam of the deflector array 295 are substantially parallel to the beam paths upbeam of the deflector array 295.

In an embodiment the objective lens array 241 comprises a plurality of plates for guiding signal electrons emitted from the sample 208 towards the deflector array 295. For the signal electrons, which travel in opposite direction with respect to the projected primary beams 211, 212, 213, the electrostatic deflector 297 does not counteract the deflection of the magnetic deflector 296. Instead, the deflections of the secondary electrons by the electrostatic deflector 297 and the magnetic deflector 296 add up. Accordingly, the signal electrons are deflected to travel at an angle with respect to the optical axis in order to transmit the secondary electrons onto the fluorescent strips 292 of the detector array 240.

At the fluorescent strips 292, photons are created upon incidence of the signal electrons. In an embodiment, the photons are transported from the fluorescent strip 292 to a photo detector (not shown) via a photon transport unit. In an embodiment, the photon transport unit comprises an array of optical fibers 298. Each optical fiber 298 comprises an end which is arranged adjacent or attached to one of the fluorescent strips 292 for coupling photons from the fluorescent strip 292 into the optical fiber 298, and another end which is arranged to project photons from the optical fiber 298 onto the photo detector. In a different arrangement, the optical to electrical converter (or photo diode) is located immediately adjacent the electron to light converter, avoiding the need for optical fibers.

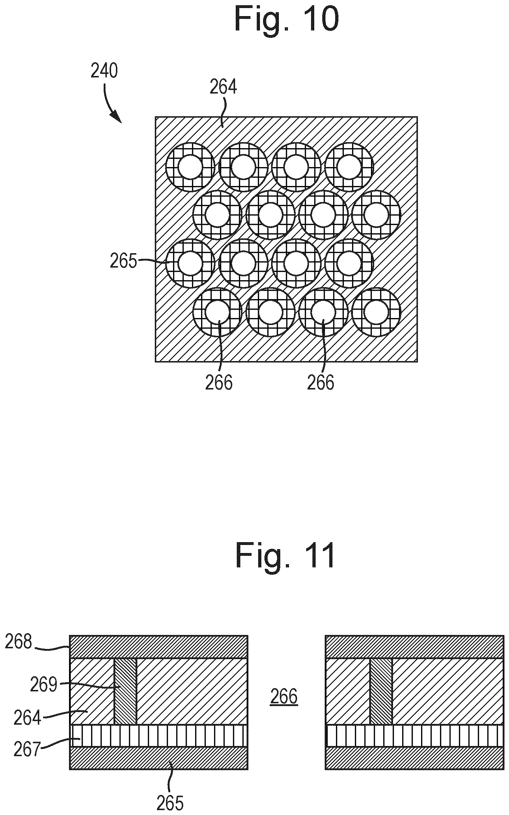

Figure 10 is a bottom view of the detector array 240 which comprises a detector substrate 264 on which are provided a plurality of detector elements 265 each surrounding a beam aperture 266. The detector array 240 may be provided at a downbeam surface of a plate 261 comprising beam apertures 266. In an embodiment, the detector elements 265 are charge capture electrodes, for example metal plates. The beam apertures 266 may be formed by etching through the detector substrate 264. In the arrangement shown in Figure 10, the beam apertures 266 are in a hexagonal close packed array. The beam apertures 266 can also be differently arranged, e.g. in a rectangular array.

Figure 11 depicts at a larger scale a part of the detector array 240 in cross section. The detector elements 265 form the bottom surface, i.e. the surface the closest to the sample 208, of the detector array 240. Between the detector elements 265 and the main body of the detector substrate 264 a logic layer 267 may be provided. At least part of the signal processing system, for example for amplification, may be incorporated into the logic layer 267.

A wiring layer 268 is provided on the backside of, or within, the detector substrate 264 and connected to the logic layer 267 by through-substrate vias 269. The number of through-substrate vias 269 need not be the same as the number of beam apertures 266. In particular if the electrode signals are digitized in the logic layer 267 only a small number of through-silicon vias may be required to provide a data bus. The wiring layer 268 may include control lines, data lines and power lines. It will be noted that in spite of the beam apertures 266 there is ample space for all necessary connections. The detector array 240 may be fabricated using CMOS technology, but may also be fabricated using bipolar or other manufacturing techniques. A printed circuit board and/or other semiconductor chips may be provided on the detector array 240.

In an embodiment the electron-optical apparatus 140 comprises a secondary electron-optical device comprising the detector array 240. In such an embodiment a beam separator typically is arranged to deflect the path of the signal electrons towards the secondary electron-optical device. The secondary electron-optical device subsequently directs the signal electrons towards the detector array 240 and focuses the signal electrons (e.g. secondary electrons) onto the detector array 240.

In an embodiment, the controller 150 is configured to control the electron-optical device 230. The controller 150 may be configured to control potentials applied to electrodes of lenses of the electron-optical device 230.

In an embodiment the controller 150 is configured to control the actuatable stage 209 to move the sample 208 during inspection of the sample 208. The controller 150 may enable the actuatable stage 209 to move the sample 208 in a direction, for example continuously, such as at a constant speed, at least during sample inspection, which may be referred to as a type of scanning. The speed of the actuatable stage 209 may be referred to as the moving rate. The controller 150 may control movement of the actuatable stage 209 so as to change the speed of movement of the sample 208 relative to the beam paths dependent on one or more parameters. The controller 150 may control deflection of scan deflectors so that the beam paths move relative to the actuatable stage 209 and thus over the surface of the sample 208. The controller 150 may change a beam deflection of a scan deflector and thus the scanning of the primary beams 211, 212, 213 over the sample 208 dependent on one or more parameters. For example, the controller 150 may control a scan deflector and/or the speed of the actuatable stage 209 and/or the direction of movement of the actuatable stage 209 depending on characteristics of the assessment process. The disclosure in EP4086933 A1 of a combined stepping and scanning strategy of the stage and scanning deflectors is hereby incorporated by reference. The moving rate may at different times comprise a stepping frequency and/or a stage scanning rate.

In order for the assessment apparatus 100 to produce images that are adequately clear for structures of the sample 208 to be measurable, it is necessary for the charged particle beam (i.e. the primary beam 211, 212, 213) to be adequately focused on the surface of the sample 208. While the focal position of the charged particle beam may be known *a priori* to a certain level of precision purely through control of the charged particle-optical device 230 and/or the actuatable stage 209, this level of precision is generally not adequate for producing high-quality images of the sample 208. Many factors may affect the actual focal position required for proper focus of the charged particle beam 211, 212, 213. For example, the charged particle-optical device 230 may suffer from various drift effects during its lifetime, or during operation of the assessment apparatus 100. Therefore, it is necessary to refine the focal position of the charged particle beam 211, 212, 213.

One approach for determining an appropriate focal position of the charged particle beam 211, 212, 213 is to perform a scan of the sample 208, and analyse the sharpness of the scan image. The analysis of the sharpness of the scan image, and thus the determination of an appropriate focal position, may be performed manually or automatically by means of image analysis algorithms. However, this approach may be slow because it may require time to scan the sample 208 and to analyse the scan image. The image analysis may also be computationally intensive. Generally, following this approach, it may take a duration on the order of 5 minutes to determine an appropriate focal position. Furthermore, this approach may also suffer from optimization errors related to convergence.

It may therefore be desirable to speed up the process of determining an appropriate focal position of the charged particle beam 211, 212, 213, and reduce the computation resources required for the process.

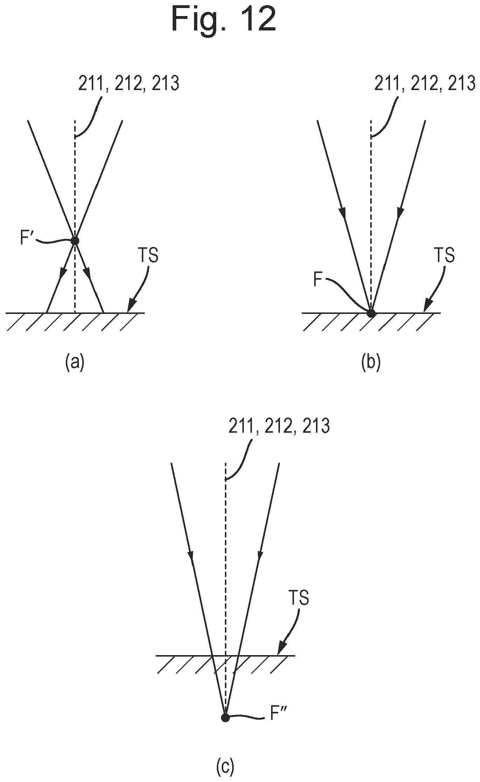

With reference to Figure 12, a method of selecting a focal position of a charged particle-optical device 230 comprises directing a charged particle beam 211, 212, 213 towards a target surface TS and detecting a detection signal resulting therefrom while varying the focal position of the charged particle beam through a range of focal positions F', F, F", thereby generating a plurality of detection signals associated with the respective focal positions F', F, F".

By way of non-limiting examples only, three focal positions F', F and F" are shown, respectively, in Figures 12(a), (b) and (c). In Figure 12(b), the focal position F of the charged particle beam 211, 212, 213 is on the target surface TS, and the charged particle beam 211, 212, 213 is in focus and impinges on the target surface TS at a small spot. In Figure 12(a), the focal position F' is in front of the target surface TS. In Figure 12(c), the focal position F" is behind the target surface TS. In both focal positions F' and F", the charted particle beam 211, 212, 213 is off-focus and impinges on the target surface TS on a larger area.

It should of course be understood that more than three focal positions F', F, F" may be used. For example, about 50, 100, 200, 300, 400, 500, 600, 700, 800, 900, or 1000 focal positions may be used. The focal positions used may cover a range in the vicinity of the focal position F when the charged particle beam 211, 212, 213 is in focus. As noted above, the focal position F may be known to a low precision *a priori,* and the range of focal positions may be chosen to be adequately wide to account for the degree of uncertainty of the focal position (e.g. due to drifts), so that the actual focal position F falls somewhere within this range.

As found by the present inventors, even though the flux (i.e. total number of particles per unit time) of the charged particle beam 211, 212, 213 may remain constant while the focal position is varied, the detection signal may be non-constant. In particular, it is observed that the detection signal may exhibit a dip when the charged particle beam 211, 212, 213 is in focus (i.e. at or near the focal position F, which is on the target surface TS). Therefore, the dip may be used as an indication that the charged particle beam 211, 212, 213 is in focus.

Accordingly, the method further comprises selecting a focal position of the charged particle-optical device 230 so that the selected focal position corresponds to a dip in the detection signal across the range of focal positions.

As can be seen, with the above method, a focal position of the charged particle-optical device 230 may be selected without needing to perform a scan of a sample 208, or to analyse any scan image using an image analysis algorithm. Therefore, the method may be able to select a focal position quickly, and without requiring significant computation resources. In an implementation, the range of focal positions may be sampled and a focal position may be selected in approximately 1 minute.

In an embodiment, the target surface TS comprises a scintillator screen. For example, the scintillator screen may be an yttrium aluminium garnet (YAG) screen. The scintillator screen may be positioned at the same level as the surface of a sample 208 to be assessed. After the focal position has been selected with the aid of the scintillator screen, the assessment apparatus 100 may proceed to assess a sample 208 by directing the charged particle beam 211, 212, 213 towards the sample 208 instead of the scintillator screen.

When the charge particle beam 211, 212, 213 impinges on the scintillator screen, photons may be emitted. Generally, the flux (i.e. total number of particles per unit time) of photons emitted may vary with the flux of charged particles impinging on the scintillator. Therefore, the greater the flux of charged particle, the greater the flux of emitted photons. The relationship between the flux of charged particles and the flux of emitted photons may generally be approximately linear. However, when the charged particle beam 211, 212, 213 is highly focused (i.e. when the flux density is high), the scintillator screen may become locally saturated, and the linear relationship may cease to hold. As a result, when the charged particle beam 211, 212, 213 is highly focused, although the flux density of charged particles is high, because of the local saturation and because the charged particles are impinging on a reduced area of the scintillator screen, the net effect may be a reduction in the flux of emitted photons. Therefore, as the focal position moves from F' through F to F" (or from F" through F to F'), a dip in the flux of emitted photons may be expected at or near focal position F.

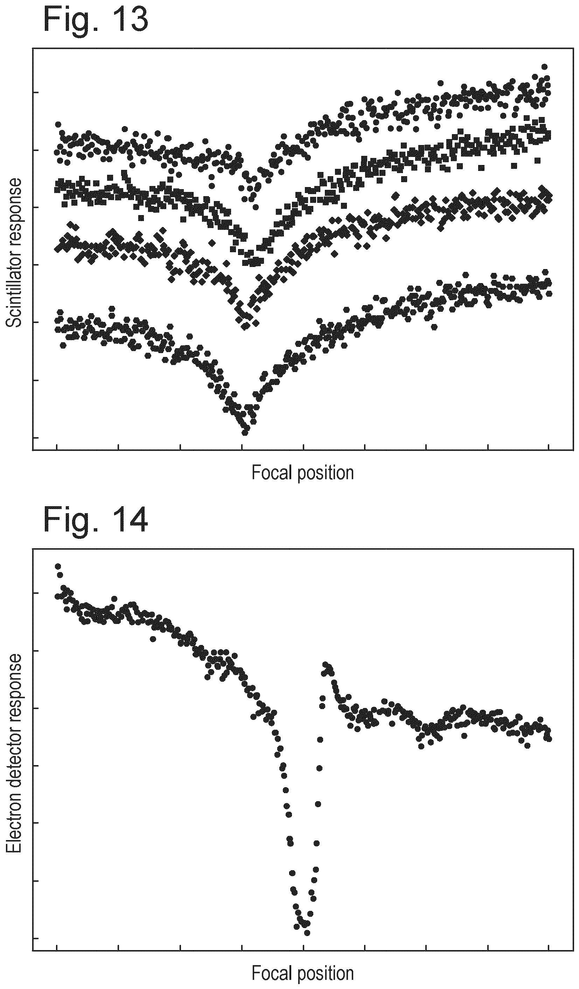

By way of example, Figure 13 shows the scintillator response (vertical axis) from four charge particle beams 211, 212, 213 across a range of focal positions (horizontal axis). As shown, the four data series exhibit a spread among one another, and there is some scattering within each data series. However, in each of the four data series, a dip in the scintillator response can be clearly recognized. The focal position at which the charger particle beam 211, 212, 213 is maximally focused is believed to be at the point where the scintillator response is at a minimum.

It should be understood that a literal measurement of the flux of photons emitted by the scintillator screen is not required. Any measurement that can stand as a proxy for photon flux may be used as the detection signal. For example, the detection signals may be measured by an image sensor. In this case, the pixel values may correlate to the number of photons impinging on the respective pixels of the image sensor within the exposure time of an image capture. For example, the sum of all the pixel values in the captured image may correspond to the total number of photons impinging on the image sensor during the exposure time, which may in turn correspond to the photon flux. The image sensor may be positioned appropriately to capture the photons emitted by the scintillator screen. For example, the image sensor may be positioned behind (i.e. on the side opposite to the side on which the charged particle beam 211, 212, 213 impinges) the scintillator screen.

In another embodiment, the target surface TS comprises a substrate surface, which may be the surface of the sample 208. As disclosed above, signal electrons may be produced as a result. Generally, the flux (i.e. total number of particles per unit time) of signal electrons emitted may vary with the flux of charged particles impinging on the substrate surface. Therefore, the greater the flux of charged particle, the greater the flux of signal electrons. However, similar to the embodiment employing a scintillator screen, as the focal position moves from F' through F to F" (or from F" through F to F'), a dip in the flux of signal electrons may be observed at or near the focal position F. This is also believed to be due to saturation. An electron detector (such as detector element 265) may be used to measure the signal electrons, and may output the detection signals. For example, the electron detector may be a secondary electron detector.

By way of example, Figure 14 shows the response of an electron detector (vertical axis) across a range of focal positions (horizontal axis). It should be noted that, in the plot of Figure 14, the electron detector response is shown as a measurement of electron flux (number of electrons per unit time). As shown, there is some scattering within the detector response. However, a dip in the electron detector response can be clearly recognized. The focal position at which the charged particle beam 211, 212, 213 is maximally focused is believed to be at the point where the electron detector response is at a minimum.

It should be understood that electron flux and conventional current are equivalent quantities with opposite polarities. The plot of Figure 14 would be upside down if the electron detector response were shown as a measurement of conventional current instead of electron flux. Purely for the avoidance of confusion, the present disclosure and the appended claims do not use the term "conventional current". It should, however, be understood that a dip in electron flux is equivalent to a peak in conventional current. Therefore, in practical implementations of the invention, it is possible to identify a peak in conventional current and select the focal position to correspond to the peak, and this is equivalent to identifying a dip in the electron flux and selecting the focal position to correspond to the dip. Accordingly, references to a dip in electron flux should be construed to encompass a peak in conventional current.

As the focal position at which the detector signal is at a minimum is believed to correspond to the focal position at which the charged particle beam 211, 212, 213 is maximally focused on the target surface TS, the method may comprise selecting this focal position as the selected focal position. However, it should be understood that the charged particle beam 211, 212, 213 may be adequately focused even if the selected focal position is not precisely at minimum point in the detector signal, provided that it corresponds to the dip in the detector signal. Furthermore, as the detection signals may be collected at a plurality of discrete sample points of the range of focal positions, the focal position at which the detection signal is at the true minimum may fall between two sample points. For simplicity, the focal position at which the detection signal is the lowest among all of the measured sample points may be treated as though it were the true minimum. Alternatively, an estimation of the true minimum point may be interpolated from the measured sample points, and the focal position at the interpolated point of minimal detector signal may be selected.

As noted above, the detection signals may be collected while varying the focal position of the charged particle beam 211, 212, 213. The focal position may be varied by different means, depending on the precise design of the charged particle-optical device 230 and/or the assessment apparatus 100 as a whole. For example, the focal position may be varied by adjusting optics of the charged particle-optical device 230. Additionally or alternatively, the focal position may be varied by moving the actuatable stage 209 closer to or further away from the charged particle-optical device 230.

Furthermore, once the focal position has been selected, the charged particle-optical device 230 and/or the assessment apparatus 100 as a whole may be configured accordingly. For example, the optics of the charged particle-optical device 230 may be configured based on the selected focal position. For example, the objective optics (e.g. the objective lens 243, the objective lens array 241) of the charged particle-optical device may be configured based on the selected focal position. More specifically, the optics of the charged particle-optical device 230 may be configured to focus the charged particle beam 211, 212, 213 at the selected focal position.

In the simplest implementation, the charged particle-optical device 230 may be a single-beam device. The present method may be applied to single-beam devices to select a focal position.

Alternatively, the charged particle-optical device 230 may be a multi-beam device, for example any of the multi-beam devices disclosed herein. With such devices, each charged particle beam 211, 212, 213 may generate a respective plurality of detection signals while the focal position of each charged particle beam 211, 212, 213 is varied.

In a multi-beam device, the step of selecting a focal position may comprise selecting a global configuration for all of the beams of the multi-beam device. For example, the global configuration may comprise a single parameter affecting the focal positions of all of the beams simultaneously.

Additionally or alternatively, in a multi-beam device, the step of varying the focal position through a range of focal positions may comprise adjusting a global parameter affecting the focal positions of all of the beams of the multi-beam device.

Generally, in a multi-beam device, due to manufacturing tolerances, wear and tear, and/or environmental drifts, for example, the focal points of the charged particle beams 211, 212, 213 may not be perfectly uniform and may exhibit some variation from one beam to another. As a result, the detection signals corresponding to the charged particle beams 211, 212, 213 may also not be perfectly uniform and may exhibit some variation from one detection signal to another. Therefore, the method may further comprise calculating a mean value of the detection signals of the multiple charged particle beams 211, 212, 213 at each focal position, and the selected focal position may correspond to a dip in the mean value across the range of focal positions.

In addition to or as an alternative to selecting a global focal position, the multi-beam charged particle-optical device 230 may comprise optics that are individually adjustable for each charged particle beam 211, 212, 213. The individually adjustable optics may be exploited to account for the non-uniformity among the multiple charged particle beams 211, 212, 213, thereby further improving the focus of each charged particle beam 211, 212, 213. Specifically, the step of selecting a focal position of the charged particle-optical device 230 may comprise selecting a focal position for each charged particle beam 211, 212, 213 individually. The selected focal position for each charged particle beam 211, 212, 213 may correspond to a dip in the detection signal corresponding to that beam. Furthermore, the configuration of the optics of each charged particle beam 211, 212, 213 may be selected individually based on the respective selected focal position.

In addition to a method of selecting a focal position, there is also disclosed a method of assessing a sample 208. Having selected a focal position of the charged particle-optical device 230, a sample 208 may be assessed by directing the charged particle beam 211, 212, 213 towards the sample 208 to be assessed.

The method of selecting a focal position and the method of assessing a sample, and variations thereof, may be implemented by computing means. As such, there is also disclosed a computer program product comprising instructions which, when executed by a processor of a charged particle-optical device 230, cause the charged particle-optical device 230 to carry out any of these methods. The controller 150 may be a suitable processor for executing these instructions.

There is also disclosed a charged particle-optical device 230 configured to carry out the method of selecting a focal position and the method of assessing a sample, and variations thereof.

There is also disclosed a charged particle-optical apparatus 140 comprising the charged particle-optical device 230, a source 201 configured to emit the charged particle beam 211, 212, 213, and an actuatable stage 209 configured to support a sample 208 at the sample location.

There is also disclosed a charged particle-optical device array 299 comprising a plurality of the charged particle-optical device 230 disclosed herein.

There is also disclosed an assessment apparatus 100 for assessing a sample 208, comprising a vacuum chamber 110, and, in the vacuum chamber 110, the charged particle-optical apparatus 140 or the charged particle-optical device array 299 disclosed herein.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Although specific reference may have been made above to the use of embodiments of the invention in the context of sample assessment, it will be appreciated that the invention, where the context allows, is not limited to sample assessment and may be used in other applications, for example electron beam lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

Aspects of the invention are described in the following numbered clauses.
Clause 1: a method of selecting a focal position of a charged particle-optical device, the method comprising:
   directing a charged particle beam towards a target surface and detecting a detection signal resulting therefrom while varying the focal position of the charged particle beam through a range of focal positions, thereby generating a plurality of detection signals associated with the respective focal positions; and
   selecting a focal position of the charged particle-optical device, wherein the selected focal position corresponds to a dip in the detection signal across the range of focal positions.
Clause 2: the method of clause 1, wherein the target surface comprises a scintillator screen.
Clause 3: the method of clause 2, wherein the scintillator screen is an yttrium aluminium garnet, YAG, screen.
Clause 4: the method of clause 2 or clause 3, wherein the detection signals comprise measurements of the flux of photons emitted by the scintillator screen.
Clause 5: the method of any one of clauses 2 to 4, wherein the detection signals are measured by an image sensor.
Clause 6: the method of clause 1, wherein the target surface is a substrate surface.
Clause 7: the method of clause 6, wherein the detection signals comprise measurements of electron flux.
Clause 8: the method of clause 6 or clause 7, wherein the detection signals are measured by an electron detector.
Clause 9: the method of clause 8, wherein the electron detector is a secondary electron detector.
Clause 10: the method of any one of the preceding clauses, wherein the selected focal position is the focal position at which the detection signal is at a minimum across the range of focal positions.
Clause 11: the method of any one of the preceding clauses, wherein the varying the focal position of the charged particle beam comprises adjusting optics of the charged particle-optical device and/or adjusting an actuatable stage configured to support the target surface.
Clause 12: the method of any one of the preceding clauses, further comprising configuring the optics of the charged particle-optical device based on the selected focal position.
Clause 13: the method of clause 12, wherein the configuring the optics comprises configuring the objective optics of the charged particle-optical device.
Clause 14: the method of clause 13, wherein the configuring the objective optics of the charged particle-optical device comprises configuring an objective lens.
Clause 15: the method of any one of the preceding clauses, wherein the charged particle-optical device is a single-beam device.
Clause 16: the method of any one of clauses 1 to 14, wherein the charged particle-optical device is a multi-beam device, and each beam generates a respective plurality of detection signals.
Clause 17: the method of clause 16, wherein the selecting a focal position of the charged particle-optical device comprises selecting a global configuration for all of the beams of the multi-beam device.
Clause 18: the method of clause 16 or clause 17, wherein the varying the focal position of the charged particle beam through a range of focal positions comprises adjusting a global parameter affecting the focal positions of all of the beams of the multi-beam device.
Clause 19: the method of any one of clauses 16 to 18, further comprising calculating a mean value of the detection signals of the multiple beams at each focal position, and the selected focal position corresponds to a dip in the mean value across the range of focal positions.
Clause 20: the method of clause 16, wherein the multi-beam charged particle-optical device comprises optics that are individually adjustable for each beam.
Clause 21: the method of clause 20, wherein the selecting a focal position of the charged particle-optical device comprises selecting a focal position for each beam individually and the selected focal position for each beam corresponds to a dip in the respective detection signal.
Clause 22: the method of clause 21, wherein the configuration of the optics of each beam is selected individually based on the respective selected focal position.
Clause 23: a method for assessing a sample, comprising:
   the method of any one of the preceding clauses; and
   directing the charged particle beam towards a sample to be assessed.
Clause 24: a computer program product comprising instructions which, when executed by a processor of a charged particle-optical device, cause the charged particle-optical device to carry out the method of any one of the preceding clauses.
Clause 25: a charged particle-optical device configured to carry out the method of any one of clauses 1 to 23.
Clause 26: a charged particle-optical apparatus comprising:
   the charged particle-optical device of clause 25;
   a source configured to emit the charged particle beam; and
   an actuatable stage configured to support a sample at the sample location.
Clause 27: a charged particle-optical device array comprising a plurality of the charged particle-optical device of clause 25.
Clause 28: an assessment apparatus for assessing a sample, comprising:
   a vacuum chamber; and
   in the vacuum chamber, the charged particle-optical apparatus of clause 26 or the charged particle-optical device array clause 27.

### List of reference numerals:

100 assessment apparatus
110 vacuum chamber (main chamber)
120 load lock chamber
124 gun aperture
125 beam limit aperture
130 EFEM
130a first loading port
130b second loading port
132a pole piece
132b control electrode
132c deflector
132d exciting coil
135 column aperture
140 electron-optical apparatus (electron beam apparatus, electron apparatus)
148 first multipole lens
150 controller
158 second multipole lens
201 source
202 source beam
204 electron-optical axis
207 sample holder
208 sample
209 actuatable stage
211, 212, 213 primary beams (sub-beams, beamlets)
220 source converter (micro-optical array)
223 pre-bending deflector array
224 aberration reduction array
230 electron-optical device (electron-optical column)
231 condenser lens array
240 detector array
241 objective lens array
242 beam shaper array
243 objective lens
250 control lens array
252 beam limiting aperture array
260 scan deflector array
261 plate
264 detector substrate
265 detector elements
266 beam apertures
267 logic layer
268 wiring layer
269 through-substrate vias
270 macro collimator
271 collimator array
272 Coulomb aperture array
273 intermediate focus plane
274 macro condenser lens
275 macro scan deflector
281-283 probe spots
291 photon converter array
292 fluorescent strip
293 openings
295 deflector array
296 magnetic deflector
297 electrostatic deflector
298 optical fiber
299 electron-optical device array
TS target surface
F, F', F" focal positions

## Claims

1. A method of selecting a focal position of a charged particle-optical device, the method comprising:
directing a charged particle beam towards a target surface and detecting a detection signal resulting therefrom while varying the focal position of the charged particle beam through a range of focal positions, thereby generating a plurality of detection signals associated with the respective focal positions; and
selecting a focal position of the charged particle-optical device, wherein the selected focal position corresponds to a dip in the detection signal across the range of focal positions.

2. The method of claim 1, wherein the target surface comprises a scintillator screen, and wherein the detection signals comprise measurements of the flux of photons emitted by the scintillator screen.

3. The method of claim 1, wherein the target surface is a substrate surface, and wherein the detection signals comprise measurements of electron flux.

4. The method of claim 3, wherein the detection signals are measured by an electron detector.

5. The method of any one of the preceding claims, wherein the selected focal position is the focal position at which the detection signal is at a minimum across the range of focal positions.

6. The method of any one of the preceding claims, wherein the varying the focal position of the charged particle beam comprises adjusting optics of the charged particle-optical device and/or adjusting an actuatable stage configured to support the target surface.

7. The method of any one of the preceding claims, further comprising configuring the optics of the charged particle-optical device based on the selected focal position.

8. The method of any one of the proceeding claims, wherein the charged particle-optical device is a multi-beam device, and each beam generates a respective plurality of detection signals.

9. The method of claim 8, wherein the selecting a focal position of the charged particle-optical device comprises selecting a global configuration for all of the beams of the multi-beam device.

10. The method of claim 8 or claim 9, wherein the varying the focal position of the charged particle beam through a range of focal positions comprises adjusting a global parameter affecting the focal positions of all of the beams of the multi-beam device.

11. The method of any one of claims 8 to 10, further comprising calculating a mean value of the detection signals of the multiple beams at each focal position, and the selected focal position corresponds to a dip in the mean value across the range of focal positions.

12. The method of claim 8, wherein the multi-beam charged particle-optical device comprises optics that are individually adjustable for each beam, and wherein the selecting a focal position of the charged particle-optical device comprises selecting a focal position for each beam individually and the selected focal position for each beam corresponds to a dip in the respective detection signal.

13. A computer program product comprising instructions which, when executed by a processor of a charged particle-optical device, cause the charged particle-optical device to carry out the method of any one of the preceding claims.

14. A charged particle-optical device configured to carry out the method of any one of claims 1 to 12.

15. A charged particle-optical apparatus comprising:
the charged particle-optical device of claim 14;
a source configured to emit the charged particle beam; and
an actuatable stage configured to support a sample at the sample location.
